Europäisches Patentamt

European Patent Office

Office européen des brevets

(19)

(11) Veröffentlichungsnummer: **0 284 844 B1**

(12)    # EUROPÄISCHE PATENTSCHRIFT

(45) Veröffentlichungstag der Patentschrift:
05.06.91 Patentblatt 91/23

(51) Int. Cl.$^5$: **H05K 1/00**

(21) Anmeldenummer: **88103636.2**

(22) Anmeldetag: **08.03.88**

(54) Rückwandleiterplatte.

(30) Priorität: **20.03.87 DE 3709119**

(43) Veröffentlichungstag der Anmeldung:
**05.10.88 Patentblatt 88/40**

(45) Bekanntmachung des Hinweises auf die
Patenterteilung:
**05.06.91 Patentblatt 91/23**

(84) Benannte Vertragsstaaten:
**CH DE FR GB LI**

(56) Entgegenhaltungen:
**EP-A- 0 004 899
EP-A- 0 195 955
DE-A- 2 233 578**

(56) Entgegenhaltungen:
**DE-U- 8 410 261
FR-A- 2 525 065
GB-A- 1 523 136
JEE, JOURNAL OF ELECTRONIC ENGINEE-
RING, Band 17, Nr. 157, Januar 1980, Seiten
30-31, Tokyo, JP; Y. GOTO: "DIP switches
achieve high density switching"**

(73) Patentinhaber: **Siemens Aktiengesellschaft
Wittelsbacherplatz 2
W-8000 München 2 (DE)**

(72) Erfinder: **Brune, Johannes, Dipl.-Ing.
Am Deckesweiher 4
W-8520 Erlangen (DE)**
Erfinder: **Latussek, Hans-Peter, Dipl.-Ing.
Heideweg 77
W-8501 Feucht (DE)**

## Beschreibung

Die Erfindung bezieht sich auf eine Rückwandleiterplatte mit mehreren parallel nebeneinander auf der den Baugruppen zugewandten Seite angeordneten Federleisten, deren Kontaktstifte auf der den Baugruppen abgewandten Seite ein Stachelfeld bilden, und mit wenigstens einem Bus, der aus wenigstens einer Busleitung besteht.

Derartige Rückwandleiterplatten sind im Handel erhältlich und beispielsweise als VME-Bus-Leiterplatte bekannt. Dabei ist der VME-Bus ein standardisierter Bus, der für den grundlegenden schnellen Datenverkehr zwischen den wichtigsten Komponenten eines Bussystems zuständig ist. Dabei bildet die Busstruktur die Verbindungsschienen zwischen den Bausteinen und -gruppen eines Mikro- oder Minicomputersystems. Je nach den verwendeten Systemkomponenten und der geforderten Leistungsfähigkeit variieren auch die Busstrukturen. Da der gesamte Datenaustausch über derartige Bussysteme erfolgt, beeinflußt deren Struktur die Leistungsfähigkeit des Gesamtsystems. Der Datenaustausch erfolgt beispielsweise im 8-, 16- oder 32-Bit-Format, d.h., es sind beispielsweise 8, 16 oder 32 Busleitungssysteme vorgesehen, die die einzelnen Baugruppen eines Bussystems untereinander verbinden. Bei derartigen baugruppenübergreifenden Bussystemen kann ein Fehler, beispielsweise ein Kurzschluß eines Ausgangstreibers mit der Versorgungsspannung eines Busteilnehmers, das gesamte Bussystem blockieren. Eine Lokalisierung des defekten Busteilnehmers ist bei vielen Fehlerarten mit Hilfe einer Diagnoseroutine möglich. Jedoch können einige Fehlerarten nur dadurch ermittelt werden, daß nacheinander alle Busteilnehmer vom Bus getrennt werden bis der defekte Teilnehmer gefunden und damit die Störung behoben ist. Beim Herausziehen der einzelnen Busteilnehmer aus ihren Steckplätzen in einem Baugruppenträger wird die gesamte Funktion des betroffenen Teilnehmers außer Betrieb gesetzt. Dies bringt erhebliche Einschränkungen der Verfügbarkeit mit sich.

Der Erfindung liegt nun die Aufgabe zugrunde, eine Rückwandleiterplatte der eingangs genannten Art so weiterzubilden, daß mindestens eine Baugruppe von einem baugruppenübergreifenden Bus abgetrennt werden kann, ohne dabei die Baugruppe selbst aus ihrem Steckplatz eines Baugruppenträgers herausziehen zu müssen.

Diese Aufgabe wird erfindungsgemäß dadurch gelöst, daß einem Buskontaktstift jeder Federleiste eines Busses ein federnder Kontaktstift zugeordnet ist, wobei die federnden Kontaktstifte jeweils mittels einer Federkraft mit dem korrespondierenden Buskontaktstift elektrisch leitend verbunden sind, daß die federnden Kontaktstifte eines Busses mittels der Busleitung elektrisch leitend miteinander verbunden sind und daß die Kontaktierung jedes federnden Kontaktstiftes mit dem korrespondierenden Buskontaktstift mittels eines Handhabungsmittels aus Isoliermaterial auftrennbar ist.

Gegenüber der bekannten Rückwandleiterplatte verbinden die Busleitungen eines Busses nicht jeweils die Buskontaktstifte der Federleisten miteinander, sondern der korrespondierenden federnden Kontaktstifte, die parallel zu den Buskontaktstiften angeordnet sind. Die Kontaktierung dieser federnden Kontaktstifte mit den Buskontaktstiften der Federleisten erfolgt mittels der Federkraft der federnden Kontakte. Durch diese federnden Kontakte kann man mittels eines Handhabungsmittels nach belieben Baugruppen, die am baugruppenübergreifende Bus angeschlossen sind, trennen, ohne dabei diejenige Baugruppe aus seinem Steckplatz in einem Baugruppenträger herauszuziehen. Somit kann man jede beliebige Baugruppe des Bussystems, die diesen Bus infolge eines Fehlers stört, vom Bus getrennt werden, wobei aber zusätzliche Funktionen, die auf diese Baugruppe angeordnet sind, in Betrieb bleiben. Dadurch wird die Verfügbarkeit dieses Systems vergrößert.

In einer vorteilhaften Ausführungsform sind die federnden Kontaktstifte jeweils einer Federleiste mit einer Haltevorrichtung aus Isoliermaterial versehen. Durch diese Gestaltung kann man nun die zusätzlichen federnden Kontakte jeder Federleiste jeweils als ein Bauteil auf der den Baugruppen abgewandten Seite der Rückwandleiterplatte aufbringen, wodurch sich die Herstellung der Rückwandleiterplatte wesentlich vereinfacht.

In einer weiteren vorteilhaften Ausführungsform ist die Haltevorrichtung mäanderförmig und im Kontaktzonenbereich jeweils der Kontaktstifte der Federleisten und der federnden Kontaktstifte mit einem Absatz versehen. Durch diese Gestaltung der Haltevorrichtung ist die Haltevorrichtung der federnden Kontaktstifte gleichzeitig eine Führung für die Kontaktstifte der Federleisten.

In einer weiteren Ausführungsform ist das Handhabungsmittel mit einer U-förmigen Haltevorrichtung versehen, der im Stegebereich Schultern angeformt sind, wobei die zu den federnden Kontaktstiften korrespondierenden Kanten der Schultern derart ausgebildet sind, daß die Trennbewegung des Handhabungsmittels sich in eine Abhebbewegung der jeweiligen federnden Kontaktstifte ändert. Dadurch, daß das Handhabungsmittel mit einer Haltevorrichtung versehen ist, kann jeweils das Handhabungsmittel in trennender Funktion auf die Kontaktstifte einer jeden Federleiste verharren, die nicht als Buskontaktstifte vorgesehen sind.

In einer weiteren Ausführungsform der Rückwandleiterplatte sind die Kontaktstifte jeweils einer Federleiste und die korrespondierenden federnden Kontaktstifte mit einem Gehäuse abgedeckt, wobei das Gehäuse mit einer Öffnung für das Handhabungsmittel versehen ist. Dadurch werden die spannungsführenden Kontaktstifte abgedeckt, so daß jedermann vor unbeabsichtigtes Berühren dieser spannungsführenden Kontaktstifte geschützt ist.

Die Aufgabe der Erfindung wird ferner gemäß dem Anspruch 9 dadurch gelöst, daß die Kontaktstifte jeder Federleiste mit einem Abstandshalter versehen sind, wobei die Abstandshalter jeweils zwischen den Federleisten und der den Baugruppen zugewandten Seite der Rückwandleiterplatte angeordnet sind, einem Kontaktstifte jeder Federleiste eines Busses ein korrespondierender Kontaktstift mit einem federnden Kontaktmittel zugeordnet ist, wobei jeweils der korrespondierende Kontaktstift einerseits mit dem Abstandshalter und andererseits mit der Rückwandleiterplatte verbunden ist und das federnde Kontaktmittel elektrisch mit dem Buskontaktstift verbunden ist, jeweils die korrespondierenden Kontaktstifte mittels der Busleitung elektrisch leitend miteinander verbunden sind und die elektrisch leitende Verbindung zwischen dem Buskontaktstift und dem federnden Kontaktmittel mittels eines Handhabungsmittels auftrennbar ist, wobei die Handhabe und der Trennteil des Handhabungsmittels auf einander abgewandten Seiten der Rückwandleiterplatte angeordnet sind.

Durch diese Gestaltung befindet sich auf der den Baugruppen abgewandten Seite der Rückwandleiterplatte nur die Handhabungsmittel, die bereits mit den Federleisten verbunden sind. Somit braucht man im Falle eines Fehlers auf irgendeiner Baugruppe eines baugruppenübergreifenden Bussystems keine Handhabungsmittel zur Lokalisierung dieses Fehlers mitbringen, sondern man braucht nur noch die vorhandenen Handhabungsmittel betätigen. Außerdem können dadurch keine Handhabungsmittel verloren gehen oder durch Unbefugte entfernt werden. Außerdem können die Handhabungsmittel nachträglich angebracht werden, so daß sich die Montage wesentlich vereinfacht, da die Rückwandleiterplatte über ein Schwallbad geführt werden kann.

Zur weiteren Erläuterung der Erfindung wird auf die Zeichnung Bezug genommen, in der Ausführungsbeispiele nach der Erfindung schematisch veranschaulicht sind.

FIG 1 zeigt einen Schnitt durch eine Rückwandleiterplatte, die mit zwei Bussen versehen ist, die
FIG 2 veranschaulicht eine Draufsicht auf der den Baugruppen abgewandten Seite der Rückwandleiterplatte nach einem Schnitt II-II nach FIG 1, die
FIG 3 zeigt eine vorteilhafte Ausführungsform eines Handhabungsmittels, die
FIG 4 stellt eine gekapselte Ausführungsform nach der Erfindung dar und die
FIG 5 veranschaulicht eine weitere vorteilhafte Ausführungsform nach der Erfindung.

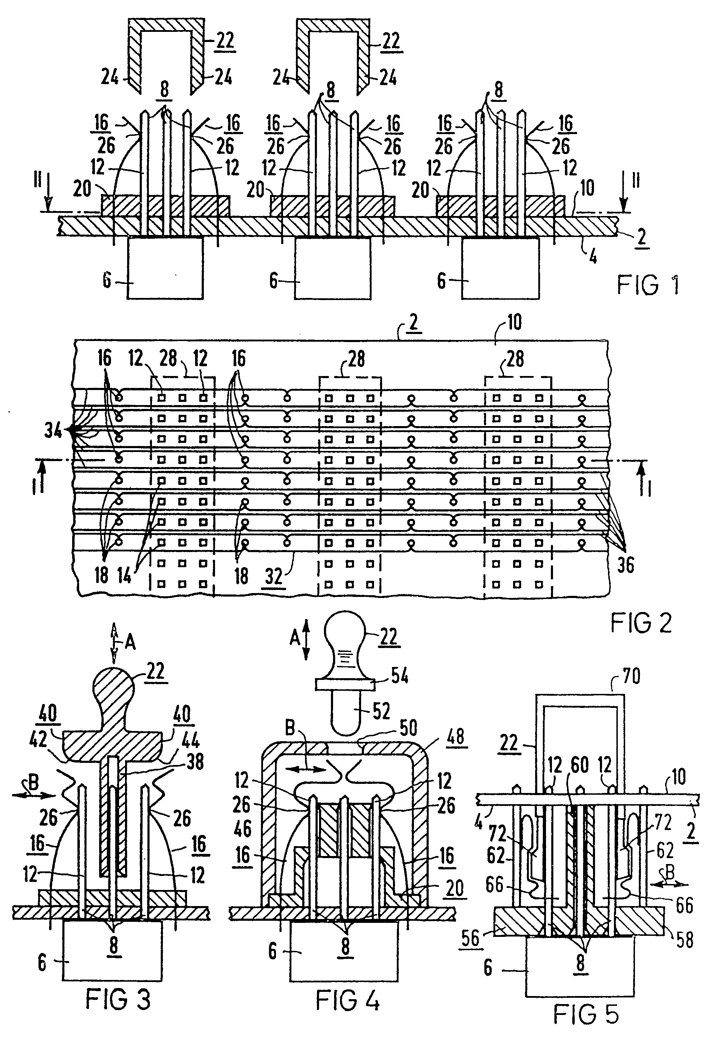

In FIG 1 ist eine Rückwandleiterplatte 2 dargestellt. Auf der den Baugruppen zugewandten Seite 4 sind mehrere parallel nebeneinander angeordnete Federleisten 6 vorhanden. Die Kontaktstifte 8 dieser Federleisten 6 bilden auf der den Baugruppen abgewandten Seite 10 ein Stachelfeld. Jedem Buskontaktstift 12 bzw. 14 ist ein federnder Kontaktstift 16 bzw. 18 zugeordnet. Die Buskontaktstifte 14 und die federnden Kontaktstifte 18 sind in der Figur nicht dargestellt, da der Schnitt durch die Rückwandleiterplatte 2 gemäß FIG 2 geführt ist. Außerdem kann man in der FIG 1 jeweils nur die Buskontaktstifte 12 oder 14 und die federnden Kontaktstifte 16 oder 18 darstellen, da diese Kontakte fluchtend in Reihen angeordnet sind, wie es die FIG 2 zeigt. Diese federnden Kontaktstifte 16 bzw. 18 sind auf der den Baugruppen abgewandten Seite 10 der Rückwandleiterplatte 2 angeordnet. Außerdem sind die federnde Kontaktstifte 16 und 18 einer jeden Federleiste 6 mit einer Haltevorrichtung 20 aus Isoliermaterial versehen. Dadurch stellen jeweils die federnden Kontaktstifte 16 und 18 und die Haltevorrichtung 20 eine Baueinheit dar. Somit können diese Baueinheiten auf der den Baugruppen abgewandten Seite 10 der Rückwandleiterplatte 2 aufgebracht werden und über ein Schwallbad geführt werden. Danach werden die Federleisten 6 von der den Baugruppen zugewandten Seite 4 der Rückwandleiterplatte 2 mit dieser verbunden. Die federnden Kontaktstifte 16 bzw. 18 werden mittels ihrer Federkraft mit den korrespondierenden Buskontaktstiften 12 bzw. 14 elektrisch leitend verbunden. Dabei ist eine ausreichend hohe Flächenpressung vorgesehen, damit entstandene Oxidschichten an den Buskontaktstiften 12 bzw. 14 unterbrochen werden. Außerdem sind Handhabungsmittel 22 vorgesehen, die U-förmig gestaltet sind und mit denen man die Kontaktierung zwischen den federnden Kontaktstiften 16 bzw. 18 und den korrespondierenden Buskontaktstiften 12 bzw. 14 steuern kann, d.h. man kann mit diesen Handhabungsmitteln 22 jeweils die elektrisch leitende Verbindung zweier korrespondierender Kontaktstifte 12 und 16 bzw. 14 und 18 trennen. Damit die Schenkel 24 des U-förmigen Handhabungsmittels 22 besser hinter den federnden Kontakten 16 bzw. 18 greifen können, sind deren freie Enden angeschrägt. Beim Aufschieben der Handhabungsmittel 22 werden die federnden Kontaktstifte 16 bzw. 18 abgehoben, wobei jeweils die Kontaktnasen 26 mit einer kratzenden Bewegung an den korrespondierenden Buskontaktstiften 12 bzw. 14 entlang bewegt werden. Durch diese Bewegung der Kontaktnasen 26 wird eine gebildete Oxidschicht an den Buskontaktstiften 12 bzw. 14 entfernt.

Die FIG 2 zeigt eine Draufsicht auf der den Baugruppen abgewandten Seite 10 der Rückwandleiterplatte 2 nach einem Schnitt II-II nach FIG 1. Die Federleisten 6, die auf der den Baugruppen zugewandten Seite 4 der Rückwandleiterplatte 2 angeordnet sind, sind auf der den Baugruppen abgewandten Seite 10 jeweils mit einer unterbrochenen Linie 28 dargestellt. Als Federleisten 6 sind jeweils beispielsweise 96-polige Federleisten vorgesehen, wobei die Kontaktstifte 8 jeweils in drei Reihen angeordnet sind. Außerdem sind zwei Busse 30 bzw. 32 vorgesehen, die jeweils acht Busleitungen 34 bzw. 36 haben. Dabei ist der Bus 32 redundant zum Bus 30 aufgebaut. Bei einem baugruppenübergreifenden Bussystem 30 mit acht Busleitungen 34 hat jede Federleiste 6 acht Buskontaktstifte 12, von denen jeweils vier Buskontaktstifte 12 in den äußeren Kontaktreihen einer jeden Federleiste 6 angeordnet sind. Da das Bussystem 30 redundant ausgeführt ist, hat jede Federleiste 6 auch acht Buskontaktstifte 14, die sich an die Buskontaktstifte 12 in den äußeren Kontaktreihen einer jeden Federleiste 6 anschließen. Jedem dieser Buskontaktstifte 12 bzw. 14 ist ein federnder Kontaktstift 16 bzw. 18 zugeordnet. Die Kontaktstifte 16 sind mittels der Busleitungen 34 des Busses 30 miteinander elektrisch leitend verbunden. Die Kontaktstifte 18 dagegen sind mittels der Busleitungen 36 des Busses 32 miteinander elektrisch leitend verbunden. Da die beiden Busse 30 und 32 ein Format von acht Busleitungen haben, so muß die Tiefe des Handhabungsmittels 22 der Breite des Busses 30 bzw. 32 entsprechen.

Im betriebsgemäßen Zustand der Rückwandleiterplatte 2 sind alle Busteilnehmer-Baugruppen an den beiden Bussen 30 und 32 angeschlossen, wobei der Datentransfer zwischen den einzelnen Busteilnehmer-Baugruppen auf dem Bus 30 stattfindet. Wenn nun ein Fehler auftritt, der diesen Bus 30 stört, kann auf den Bus 32 umgeschaltet werden, da beide Busse 30 und 32 redundant aufgebaut sind. Dadurch bleibt trotz eines auftretenden Fehlers das System in Betrieb. Die Fehlersuche erfolgt nun auf dem gestörten Bus 30, indem man nacheinander die Baugruppen mittels der Handhabungsmittel 22 vom Bus 30 trennt. In Verbindung mit einer geeigneten Testroutine wird festgestellt, bei welcher Baugruppe die Blockierung des Busses 30 behoben ist. Die so lokalisierte defekte Busteilnehmer-Baugruppe kann nun ausgetauscht werden. Durch diese indirekte Ankopplung der Busteilnehmer-Baugruppen an die baugruppenübergreifenden Busse 30 und 32 können jederzeit einzelne Baugruppen von den Bussen 30 bzw. 32 getrennt werden, ohne dabei die Baugruppe aus ihrem Steckplatz eines Baugruppenträgers herausziehen zu müssen und ohne dabei das System abschalten zu müssen. Dadurch bleiben zusätzliche Funktionen dieser vom Bus getrennten Baugruppen in Betrieb, wodurch die Verfügbarkeit des Systems vergrößert wird.

Die FIG 3 zeigt ein vorteilhaftes Handhabungsmittel 22. Dieses Handhabungsmittel 22 ist mit einer U-förmigen Haltevorrichtung 38 versehen, der seitwärts Schultern 40 angeformt sind. Die zu den federnden Kontaktstiften 16 oder 18 korrespondierenden Kanten 42 und 44 der Schultern 40 sind derartig ausgebildet, daß die Trennbewegung des Handhabungsmittels 22, gekennzeichnet durch einen Doppelpfeil A, sich in eine Abhebbewegung der federnden Kontaktstifte 16 bzw. 18, gekennzeichnet durch einen Doppelpfeil B, ändert. Bei diesem Bewegungsablauf bewegt sich jeweils auch die Kontaktnase 26 der federnden Kontaktstifte 16 oder 18 entlang der korrespondierenden Kontaktstifte 12 oder 14, wodurch eine entstandene Oxidschicht abgekratzt wird. Durch die Haltevorrichtung 38 wird einerseits das Handhabungsmittel 22 geführt und andererseits kann das Handhabungsmittel 22 in der trennenden Position besser verharren.

Die FIG 4 zeigt eine gekapselte Ausführungsform, wobei die Haltevorrichtung 20 mäanderförmig ist. Außerdem ist die Haltevorrichtung 20 im Kontaktzonenbereich mit einem Absatz 46 versehen. Durch diese Gestaltung der Haltevorrichtung 20 werden jeweils die Kontaktstifte 8 der Federleiste 6 geführt und justiert. Auch bei dieser Ausführungsform sind die federnden Kontaktstifte 16 bzw. 18 mit der Haltevorrichtung 20 verbunden. Die Kontaktierung zwischen den federnden Kontaktstiften 16 bzw. 18 und den korrespondierenden Buskontaktstiften 12 bzw. 14 erfolgt mittels der Federkraft der Kontaktstifte 16 bzw. 18. Ferner sind die Kontaktstifte 16 und 18 mit Kontaktnasen 26 versehen, so daß eine entstandene Oxidschicht auf den korrespondierenden Buskontaktstiften 12 und 14 einerseits durch eine Flächenpressung und/oder andererseits durch eine kratzende Bewegung beim Trennen der Kontaktstifte 12 und 16 bzw. 14 und 18 mittels des Handhabungsmittels 22 entfernt wird. Diese spannungsführenden Kontaktstifte 12, 14, 16 und 18 sind mit einem Gehäuse 48 abgedeckt, wobei das Gehäuse mit einer Öffnung 50 für das Handhabungsmittel 22 versehen ist. Auch bei dieser Ausführungsform ist das Trennteil 52 des Handhabungsmittels 22 derart gestaltet, daß die Trennbewegung, durch einen Doppelpfeil A dargestellt, sich in eine Abhebbewegung der federnden Kontaktstifte 16 bzw. 18, durch einen Doppelpfeil B gekennzeichnet, ändert. Außerdem ist das Handhabungsmittel 22 mit seitwärts angebrachten Abstützmitteln 54 versehen, mit denen sich das Handhabungsmittel 22 auf das Gehäuse 48 abstützen kann.

In der FIG 5 wird eine weitere vorteilhafte Ausführungsform nach der Erfindung veranschaulicht. Dabei sind die Federleisten 6, von denen nur eine dargestellt ist, mit Abstandshaltern 56 versehen, wobei die Abstandshalter 56 jeweils zwischen den Federleisten 6 und der den Baugruppen zugewandten Seite 4 der Rückwandleiterplatte 2 angeordnet sind. Der Abstandshalter 56 besteht aus einer Grundplatte 58 und einer U-förmigen Führung 60. Die Grundplatte 58 ist mit Bohrungen versehen, die in Reihen angeordnet sind. Wenigstens eine Reihe ist in Flucht der U-förmigen Führung 60 angeordnet. Außerdem hat die Grundplatte 58 korrespondierende Kontaktstifte 62 bzw. 64, die jeweils ein federndes Kontaktmittel 66 bzw. 68 haben. Die korrespondierenden Kontaktstifte 64 bzw. die federnden Kontaktmittel 68 sind in dieser FIG nicht dargestellt, da sie durch die korrespondierenden Kontaktstifte 62 bzw. durch die federnden Kontaktstifte 66 verdeckt werden. Auch bei dieser Ausführungsform sind die Kontaktstifte 62 bzw. 64 und die Kontaktstifte 66 bzw. 68 in Reihen angeordnet gemäß FIG 2. Diese korrespondierenden Kontaktstifte 62 bzw. 64 sind einerseits mit der Grundplatte 58 und andererseits mit der Rückwandleiterplatte 2 verbunden. Die federnden Kontaktmittel 66 bzw. 68 werden mit Hilfe ihrer Federkraft gegen korrespondierende Buskontaktstifte 12 bzw. 14 dermaßen gedrückt, daß entstandene Oxidschichten an den Buskontaktstiften 12 bzw. 14 entfernt werden. Da die Kontaktstifte 8 der Federleisten 6 pfostenförmig sind, ist es besonders vorteilhaft, wenn die federnden Kontaktmittel 66 und 68 keilförmig ausgebildet sind, so daß sie die korrespondierenden Buskontaktstifte teilweise umgreifen. Bei der Ausführungsform des Handhabungsmittels 22 sind die Handhabe 70 und der Trennteil 72 auf einander gegenüberliegenden Seiten 4 und 10 der Rückwandleiterplatte 2 angebracht. Dabei ist jeweils der Teil des Trennteils 72 des Handhabungsmittels 22, auf dem sich das federnde Kontaktmittel 66 bzw. 68 abstützt, derart gestaltet, daß eine Trennbewegung, gekennzeichnet durch einen Doppelpfeil A, sich in eine Abhebbewegung des federnden Kontaktmittels 66 bzw. 68, gekennzeichnet durch einen Doppelpfeil B, ändert. Bei diesem Bewegungsablauf werden die federnden Kontaktmittel 66 bzw. 68 kratzend an den korrespondierenden Buskontaktstiften 12 bzw. 14 entlang geführt. Dadurch werden ebenfalls entstandene Oxidschichten entfernt. Bei dieser Ausführungsform brauchen keine Handhabungsmittel 22 eingeführt werden. Außerdem können keine Handhabungsmittel 22 verlorengehen. Ferner braucht derjenige, der eine derartig aufgebaute Rückwandleiterplatte 2 reparieren muß, keine Handhabungsmittel 22 mitbringen. Da die Handhabe 70 der Handhabungsmittel 22 auf der den Baugruppen abgewandten Seite 10 der Rückwandleiterplatte 2 angeordnet sind, vereinfacht sich die Fehlerortung bei einem auftretenden Fehler in einer Baugruppe des baugruppenübergreifenden Bussystems.

**Ansprüche**

1. Rückwandleiterplatte (2) mit mehreren parallel nebeneinander auf der den Baugruppen zugewandten Seite (4) angeordneten Federleisten (6), deren Kontaktstifte (8) auf der den Baugruppen abgewandten Seite (10) ein Stachelfeld bilden, und mit wenigstens einem Bus (30, 32), der aus wenigstens einer Busleitung (34, 36) besteht, **dadurch gekennzeich-** net, daß einem Buskontaktstift (12, 14) jeder Federleiste (6) eines Busses (30, 32) ein federnder Konstaktstift (16, 18) zugeordnet ist, wobei die federnden Kontaktstifte (16, 18) jeweils mittels einer Federkraft mit dem korrespondierenden Buskontaktstift (12, 14) elektrisch leitend verbunden sind, daß die federnden Kontaktstifte (16, 18) eines Busses (30, 32) mittels der Busleitung (34, 36) elektrisch leitend miteinander verbunden sind und daß die Kontaktierung jedes federnden Kontaktstiftes (16, 18) mit dem korrespondierenden Buskontaktstiftes (12, 14) mittels eines Handhabungsmittels (22) aus Isoliermaterial auftrennbar ist.

2. Rückwandleiterplatte (2) nach Anspruch 1, **dadurch gekennzeichnet,** daß die federnden Kontaktstifte (16, 18) jeweils einer Federleiste (6) mit einer Haltevorrichtung (20) aus Isoliermaterial versehen sind.

3. Rückwandleiterplatte (2) nach Anspruch 2, **dadurch gekennzeichnet,** daß als Haltevorrichtung (20) eine Platte vorgesehen ist.

4. Rückwandleiterplatte (2) nach Anspruch 2, **dadurch gekennzeichnet,** daß die Haltevorrichtung (20) mäanderförmig ist und im Kontaktzonenbereich jeweils der Kontaktstifte (8) der Federleisten (6) und der federnden Kontaktstifte (16, 18) mit einem Absatz (46) versehen ist.

5. Rückwandleiterplatte (2) nach Anspruch 1, **dadurch gekennzeichnet,** daß das Handhabungsmittel (22) U-förmig ist, wobei die Enden deren Schenkel (24) angeschrägt sind.

6. Rückwandleiterplatte (2) nach Anspruch 1, **dadurch gekennzeichnet,** daß das Handhabungsmittel (22) mit einer U-förmigen Haltevorrichtung (38) versehen ist, der im Stegbereich Schultern (40) angeformt sind, wobei die zu den federnden Kontaktstiften (16, 18) korrespondierenden Kanten (42, 44) der Schultern (40) derart ausgebildet sind, daß die Trennbewegung des Handhabungsmittels (22) sich in eine Abhebbewegung der federnden Kontaktstifte (16, 18) ändert.

7. Rückwandleiterplatte (2) nach Anspruch 1, **dadurch gekennzeichnet,** daß das Handhabungsmittel (22) mit einem stegförmigen Trennteil (52) und mit seitwärts angebrachten Abstützmitteln (54) versehen ist, wobei das freie Ende des Trennteils (52) abgerundet ist.

8. Rückwandleiterplatte (2) nach Anspruch 1, **dadurch gekennzeichnet,** daß die Kontaktstifte (8) einer jeden Federleiste (6) und die korrespondierenden federnden Kontaktstifte (16, 18) mit einem Gehäuse (48) abgedeckt sind, wobei das Gehäuse (48) mit einer Öffnung (50) für das Handhabungsmittel (22) versehen ist.

9. Rückwandleiterplatte (2) mit mehreren parallel nebeneinander auf der den Baugruppen zugewandten Seite (4) angeordneten Federleisten (6) und mit wenigstens einem Bus (30, 32), der aus einer Busleitung (34, 36) besteht, **dadurch gekennzeichnet,** daß die Kontaktstifte (8) jeder Federleiste (6) mit einem Abstandshalter (56) versehen sind, wobei die Abstandshalter (56) jeweils zwischen den Federleisten (6) und der den Baugruppen zugewandten Seite (4) der Rückwandleiterplatte (2) angeordnet sind, daß einem Buskontaktstift (12, 14) jeder Federleiste (6) eines Busses (30, 32) ein korrespondierender Kontaktstift (62, 64) mit einem federnden Kontaktmittel (66, 68) zugeordnet ist, wobei jeweils der korrespondierende Kontaktstift (62, 64) einerseits mit dem Abstandshalter (56) und andererseits mit der Rückwandleiterplatte (2) verbunden ist und das federnde Kontaktmittel (66, 68) elektrisch leitend mit dem Buskontaktstift (12, 14) verbunden ist, daß jeweils die korrespondierenden Kontaktstifte (62, 64) mittels der Busleitung (34, 36) elektrisch leitend miteinander verbunden sind, und daß die elektrisch leitende Verbindung zwischen dem Buskontaktstift (12, 14) und dem federnden Kontaktmittel (66, 68) mittels eines Handhabungsmittels (22) auftrennbar ist, wobei die Handhabe (70) und der Trennteil (72) des Handhabungsmittels (22) auf einander abgewandten Seiten (4, 10) der Rückwandleiterplatte (2) angeordnet sind.

10. Rückwandleiterplatte (2) nach Anspruch 9, **dadurch gekennzeichnet,** daß der Kontaktbereich des federnden Kontaktmittels (66, 68) keilförmig ausgebildet ist.

11. Rückwandleiterplatte (2) nach Anspruch 9, **dadurch gekennzeichnet,** daß der Trennteil (72) des Handhabungsmittels (22), auf dem sich das federnde Kontaktmittel (66, 68) abstützt, derart gestaltet sind, daß eine Trennbewegung des Trennteils (72) sich in eine Abhebbewegung des federnden Kontaktmittels (66, 68) ändert.

12. Rückwandleiterplatte (2) nach Anspruch 9, **dadurch gekennzeichnet,** daß der Trennteil (72) des Handhabungsmittels (22) aus Isoliermaterial besteht.

## Claims

1. A backplane printed circuit board (2) with several socket connectors (6) arranged parallel to one another side by side on the side (4) of the backplane printed circuit board that faces the module, the contact pins (8) of which connectors form a pin field on the side (10) that faces away from the modules, and with at least one bus (30, 32) consisting of at least one bus line (34, 36), characterised in that a resilient contact pin (16,18) is allocated to a bus contact pin (12,14) of each socket connector (6) of a bus (30,32), wherein the resilient contact pins (16, 18) are connected in an electrically conducting manner in each case by means of spring force with the corresponding bus contact pin (12, 14), in that the resilient contact pins (16, 18) of a bus (30,32) are connected in an electrically conducting manner to each other by means of the bus line (34,36) and in that the contact of each resilient contact pin (16, 18) is able to be separated with the corresponding bus contact pin (12, 14) by means of handling means (22) made of insulating material.

2. A backplane printed circuit board (2) according to claim 1, characterised in that the resilient contact pins (16, 18) of a respective socket connector (6) are provided with a holding device (20) of insulating material.

3. A backplane printed circuit board (2) according to claim 2, characterised in that a plate is provided as holding device (20).

4. A backplane printed circuit board (2) according to claim 2, characterised in that the holding device (20) is meander-shaped and in the contact zone region of the respective contact pins (8) of the socket connectors (6) and of the resilient contact pins (16, 18) is provided with a step (46).

5. A backplane printed circuit board (2) according to claim 1, characterised in that the handling means (22) are U-shaped, wherein the ends of the legs (24) thereof are bevelled.

6. A backplane printed circuit board (2) according to claim 1, characterised in that the handling means (22) are provided with a U-shaped holding device (38), and in the flanged area shoulders (40) are preformed, wherein the edges (42, 44) of the shoulders (40), corresponding to the resilient contact pins (16, 18) are constructed such that separating motion of the handling means (22) is converted into a lifting motion of the resilient contact pins (16, 18).

7. A backplane printed circuit board (2) according to claim 1, characterised in that the handling means (22) is provided with a web-formed separator part (52) with supporting means (54) attached laterally, wherein the free end of the separator part (52) is rounded off.

8. A backplane printed circuit board (2) according to claim 1, characterised in that the contact pins (8) of each socket connector (6) and the corresponding resilient contact pins (16, 18) are covered with a housing (48), wherein the housing (48) is provided with an opening (50) for the handling means (22).

9. A backplane printed circuit board (2) with several socket connectors (6) arranged parallel to one another, side by side on the side (4) of the backplane printed circuit board that faces the modules and with at least one bus (30, 32) which consists of a bus line (34,36), characterised in that the contact pins (8) of each socket connector (6) are provided with a spacer (56), wherein the spacers (56) are arranged in each case between the socket connectors (6) and the side (4) facing the modules of the backplane printed circuit board (2), in that allocated to a bus contact pin (12, 14) of each socket connector (6) of a bus (30, 32) there is a corresponding contact pin (62, 64) with a resilient contact means (66, 68), wherein the respective corresponding contact pin (62, 64) is connected, on the one side, to the spacer (56) and, on the other side, to the backplane printed circuit board (2), and the resilient contact means (66, 68) are connected in an electrically conducting manner to the bus contact pin (12, 14), in that the respective corresponding contact pins (62, 64) are connected by means of the bus line (34, 36) in an electrically conducting manner, and in that the electrically conducting connection between the bus contact pin (12, 14) and the resilient contact means (66, 68) is able to be separated by means of a handling means (22), wherein the handle (70) and the separator part (72) of the handling means (22) are arranged on sides (4, 10) of the backplane printed circuit board (2) facing away from each other.

10. A backplane printed circuit board (2) according to claim 9, characterised in that the contact region of the resilient contact means (66, 68) is wedge-shaped.

11. A backplane printed circuit board (2) according to claim 9, characterised in that the separator part (72) of the handling means (22) on which the resilient contact means (66, 68) rests, is shaped such that the separating motion of the separator part (72) is converted into a lifting motion of the resilient contact means (66, 68).

12. A backplane printed circuit board (2) according to claim 9, characterised in that the separator part (72) of the handling means (22) consists of insulating material.

## Revendications

1. Plaquette à circuits imprimés de paroi arrière (2) comportant plusieurs barrettes à ressorts (6), qui sont disposées parallèlement côte-à-côte sur la face (4) tournée vers les modules et dont les broches de contact (8) forment un panneau de pointes sur la face (10) tournée à l'opposé des modules, et au moins un bus (30, 32) formé par au moins une ligne (34 et 36), caractérisée par le fait qu'à une broche de contact de bus (12, 14) de chaque barrette à ressorts (6) d'un bus (32) est associée une broche élastique de contact (16, 18), les broches élastiques de contact (16, 18) étant raccordées d'une manière électriquement conductrice respectivement au moyen de la force d'un ressort à la broche de contact de bus correspondante (12, 14), que les broches élastiques de contact (16, 18) d'un bus (30, 32) sont raccordées entre elles de manière électriquement conductrice à l'aide de la ligne (34, 36), et que le contact entre chaque broche élastique de contact (16, 18) et la broche de contact de bus correspondante (12, 14) peut être interrompu à l'aide d'un dispositif à poignée (22) réalisé en un matériau isolant.

2. Plaquette à circuits imprimés de paroi arrière (2) suivant la revendication 1, caractérisée par le fait que les broches élastiques de contact (16, 18) comportent respectivement une barrette à ressorts (6) comportant un dispositif de retenue (20) réalisé en un matériau isolant.

3. Plaquette à circuits imprimés de paroi arrière (2) suivant la revendication 2, caractérisée par le fait qu'une plaque est prévue comme dispositif de retenue (20).

4. plaquette à circuits imprimés de paroi arrière (2) suivant la revendication 2, caractérisée par le fait que le dispositif de retenue (20) possède une forme sinueuse et comporte une partie étagée (46) au niveau des zones de contact des broches respectives de contact (8) des barrettes à ressorts (6) et des broches élastiques de contact (16, 18).

5. Plaquette à circuits imprimés de paroi arrière (2) suivant la revendication 1, caractérisée par le fait que le dispositif à poignée (22) possede une forme en U, dont les extrémités des branches (24) sont biseautées.

6. Plaquette à circuits imprimés de paroi arrière (2) suivant la revendication 1, caractérisée par le fait que le dispositif à poignée (22) comporte un dispositif de retenue (36) en forme de U, dans la partie formant base duquel sont formés par moulage des épaulements (40), les bords (42, 44), qui correspondent aux broches élastiques de contact (16, 18), des épaulements (40) étant agencés de telle sorte que le mouvement de séparation du dispositif à poignée (22) se transforme en un mouvement d'écartement des broches élastiques de contact (16, 18).

7. Plaquette à circuits imprimés de paroi arrière (2) suivant la revendication 1, caractérisée par le fait que le dispositif à poignée (22) comporte une partie de séparation (52) en forme de barrette et comporte des moyens d'appui latéraux (54), l'extrémité libre de la partie de séparation (52) étant arrondie.

8. Plaquette à circuits imprimés de paroi arrière (2) suivant la revendication 1, caractérisée par le fait que les broches de contact (8) de chaque barrette à ressorts (6) et les broches élastiques de contact correspondantes (16, 18) sont recouvertes par un boîtier (48) comportant une ouverture (50) pour le dispositif à poignée (22).

9. Plaquette à circuits imprimés de paroi arrière (2) comportant plusieurs barrettes à ressorts (6) disposées parallèlement côte-à-côte sur la face (4) tournée vers les modules, et au moins un bus (30, 32) constitué par une ligne (34, 36), caractérisée par le fait que les broches de contact (8) de chaque barrette à ressorts (6) sont équipées d'une entretoise (56), les entretoises (56) étant disposées respectivement entre les barrettes à ressorts (6) et la face (4), tournée vers les modules, de la plaquette à circuits imprimés de paroi arrière (2), qu'à une broche de contact de bus (12, 14) de chaque barrette à ressorts (6) d'un bus (30, 32) est associée une barrette de contact correspondante (62, 64) possédant un moyen élastique de contact (66, 68), la broche de contact correspondante (62, 64) étant raccordée d'une part à l'entretoise (56) et d'autre part à la plaquette à circuits imprimés de paroi arrière (2), tandis que le mnyen élastique de contact (66, 68) est raccordé d'une manière électriquement conductrice à la broche de contact de bus (12, 14), que les broches de contact respectives correspondantes (62, 64) sont raccordées d'une arrière électriquement conductrice entre elles au moyen de la ligne (34, 36) du bus, et que la liaison électriquement conductrice entre la broche de contact de bus (12, 14) et le moyen élastique de contact (66, 68) est séparable au moyen d'un dispositif à poignée, la poignée (70) et la partie de séparation (72) du dispositif à poignée (22) étant disposées sur des faces (4, 10), tournées à l'opposé l'une de l'autre, de la plaquette à circuits imprimés de paroi arrière (2).

10. Plaquette à circuits imprimés de paroi arrière (2) suivant la revendication 9, caractérisé par le fait que la zone de contact du moyen élastique de contact (66, 68) possède une forme en coin.

11. Plaquette à circuits imprimés de paroi arrière (2) suivant la revendication 9, caracterisée par le fait que la partie de séparation (72) du dispositif à poignée (22), sur lequel prend appui le moyen élastique de contact (66, 68), est agencée de telle sorte qu'un mouvement de séparation de la partie de séparation (72) se transforme en un mouvement d'écartement du moyen élastique de contact (66, 68).

12. Plaquette à circuits imprimés de paroi arrière (2) suivant la revendication 9, caractérisée par le fait que la partie de séparation (72) du dispositif à poignée (22) est réalisée en un matériau isolant.

FIG 1

FIG 2

FIG 3

FIG 4

FIG 5